# FASCICULE DE BREVET EUROPEEN

(11) **EP 4 568 060 B1**
(45) Date de publication et mention de la délivrance du brevet: **12.08.2026**
(21) Numéro de dépôt: 24214694.2
(22) Date de dépôt: 22.11.2024
(51) Int. Cl.: H02J 7/00, G01R 31/392

(54) **MÉTHODE ET DISPOSITIF POUR GÉNÉRER UN PASSEPORT NUMÉRIQUE D'UNE CELLULE DE BATTERIE LITHIUM-ION**
VERFAHREN UND VORRICHTUNG ZUR ERZEUGUNG EINES DIGITALEN REISEPASSES EINER LITHIUM-IONEN-BATTERIEZELLE
METHOD AND APPARATUS FOR GENERATING A DIGITAL PASSPORT OF A LITHIUM ION BATTERY CELL

(30) Priorité: 29.11.2023 FR 2313263
(43) Date de publication de la demande: 11.06.2025
(73) Titulaire: Commissariat à l'Energie Atomique et aux Energies Alternatives, 75015 Paris (FR)
(72) Inventeur: DESEURE, Jonathan, 38054 GRENOBLE CEDEX 09 (FR); BICHOT, Lauriane, 38054 GRENOBLE CEDEX 09 (FR); MONTARU, Maxime, 38054 GRENOBLE CEDEX 09 (FR)
(74) Mandataire: Santarelli

(56) Documents cités:
- CN-A- 111 308 379
- LI KAIQUAN ET AL: "A comparative study of battery state-of-health estimation based on empirical mode decomposition and neural network", JOURNAL OF ENERGY STORAGE, vol. 54, 1 October 2022 (2022-10-01), NL, pages 105333, XP093176794, ISSN: 2352-152X, DOI: 10.1016/j.est.2022.105333
- RUAN HAOKAI ET AL: "State of Health Estimation of Lithium-Ion Battery Based on Constant-Voltage Charging Reconstruction", IEEE JOURNAL OF EMERGING AND SELECTED TOPICS IN POWER ELECTRONICS, IEEE, PISCATAWAY, NJ, USA, vol. 11, no. 4, 20 July 2021 (2021-07-20), pages 4393 - 4402, XP011945626, ISSN: 2168-6777, [retrieved on 20210721], DOI: 10.1109/JESTPE.2021.3098836
- XIA FEI ET AL: "State of health and remaining useful life prediction of lithium-ion batteries based on a disturbance-free incremental capacity and differential voltage analysis method", JOURNAL OF ENERGY STORAGE, ELSEVIER BV, NL, vol. 64, 24 March 2023 (2023-03-24), XP087298776, ISSN: 2352-152X, [retrieved on 20230324], DOI: 10.1016/J.EST.2023.107161

## Description

### Domaine de l'invention

La présente invention appartient au domaine de la gestion des batteries de type « Lithium-Ion ». Plus particulièrement, il est proposé une méthode et un dispositif pour générer un passeport numérique d'une cellule de batterie Lithium-Ion, dans le but d'offrir une représentation synthétique et facilement exploitable de l'état de santé de la cellule. Ce passeport numérique peut notamment être utilisé pour évaluer la possibilité de réutiliser la cellule en seconde vie.

### Etat de la technique

La proposition de règlement sur les batteries 2020/353 (COD), abrogeant la directive européenne 2006/66/EC et modifiant le règlement de l'Union européenne (UE) n° 2019/1020, vise à améliorer la gestion des batteries au lithium et des déchets de ces batteries dans l'Union européenne. La proposition prévoit une série de mesures visant notamment à augmenter le taux de collecte des batteries, à réduire la quantité de substances dangereuses contenues dans les batteries et à améliorer le recyclage des batteries. Cela permettra de protéger l'environnement et de préserver les ressources naturelles. Cette proposition de règlement sur les batteries est actuellement en cours d'examen par le Parlement européen et le Conseil de l'Union européenne.

Cette proposition de règlement introduit également la notion de « passeport numérique de batterie » permettant de fournir des données synthétiques et facilement exploitables vis-à-vis de la sécurité de la batterie, de son démantèlement et/ou de sa réutilisation en seconde vie.

Il n'y a toutefois pas de recommandation spécifique sur la nature exacte des données que doit contenir le passeport numérique pour donner un aperçu de l'état de santé de la batterie et de la possibilité ou non de la réutiliser en seconde vie.

De nombreuses méthodes de diagnostic sont déjà connues pour estimer un état de santé d'une batterie au lithium. Ces méthodes de diagnostic se basent en général sur des signaux de tension mesurés au niveau de la batterie, comme par exemple dans les demandes de brevet US 2017/146608 A1 et US 2022/0381849 A1. La demande de brevet EP 3324197 A1 décrit quant à elle une méthode pour déterminer l'état de santé d'une cellule de batterie en fonction d'un rapport entre une variation de charge et une différence de courant mesurées entre deux instants d'une phase CV (phase de charge à tension constante) d'un cycle CC-CV (cycle de charge comportant une phase de charge à courant constant suivi d'une phase de charge à tension constante). La fiabilité de ces méthodes n'est cependant pas toujours pleinement satisfaisante.

### Exposé de l'invention

La présente invention a pour objectif de remédier à tout ou partie des inconvénients de l'art antérieur, notamment ceux exposés ci-avant.

A cet effet, et selon un premier aspect, il est proposé par la présente invention, une méthode pour générer un passeport numérique d'une cellule d'une batterie Lithium-lon. Le passeport numérique prend la forme d'un fichier informatique comportant un ensemble de valeurs d'incidence représentatives d'un historique d'états de santé de la cellule au cours d'une première vie de la cellule. La méthode comporte, pour chaque phase « tension constante » (phase CV) d'un ensemble de cycles de charge « courant constant - tension constante » (cycles de charge CC-CV) de la cellule au cours de sa première vie :
- une collecte d'une pluralité de mesures de courant effectuées au niveau de la cellule pendant la phase CV considérée, ladite pluralité de mesures formant un signal de « courant de floating »,
- une dérivation du signal de courant de floating pour obtenir un signal de dérivée de courant de floating,
- une décomposition en modes empiriques du signal de dérivée de courant de floating afin d'en obtenir une représentation sous la forme d'une somme d'un signal résiduel et d'une ou plusieurs composantes intrinsèques,
- une détermination d'une valeur d'incidence représentative d'un état de santé de la cellule, pour la phase CV considérée, à partir des composantes intrinsèques ainsi obtenues,
- une mémorisation dans le fichier informatique de la valeur d'incidence déterminée associée à une information sur l'instant d'occurrence de la phase CV considérée.

Dans des modes particuliers de mise en oeuvre, l'invention peut comporter en outre l'une ou plusieurs des caractéristiques suivantes, prises isolément ou selon toutes les combinaisons techniquement possibles.

Dans des modes particuliers de mise en oeuvre, la détermination de la valeur d'incidence, pour la phase CV considérée, comprend :
- un calcul d'une énergie pour chaque composante intrinsèque,
- un calcul d'une énergie intrinsèque totale égale à une somme des énergies des composantes intrinsèques,
- une détermination de la valeur d'incidence, pour la phase CV considérée, en fonction de l'énergie intrinsèque totale ainsi calculée.

Dans des modes particuliers de mise en œuvre, la détermination de la valeur d'incidence, pour la phase CV considérée, comprend :
- un calcul d'une densité spectrale pour chaque composante intrinsèque,
- un calcul d'une densité spectrale intrinsèque totale égale à une somme des densités spectrales des différentes composantes intrinsèques,
- une détermination de la valeur d'incidence, pour la phase CV considérée, en fonction de la densité spectrale intrinsèque totale ainsi calculée.

Dans des modes particuliers de mise en œuvre, la densité spectrale intrinsèque totale est normalisée par rapport à une valeur maximale de la densité spectrale intrinsèque totale.
Dans des modes particuliers de mise en œuvre, pour chaque composante intrinsèque, la densité spectrale de la composante intrinsèque est calculée à partir d'une transformée de Hilbert de la composante intrinsèque.

La méthode proposée se distingue nettement des méthodes conventionnelles en ce qu'elle se base sur l'analyse de la dérivée du courant de floating pendant une phase CV d'un cycle de charge CC-CV. Rien ne suggère au premier abord que ce signal renferme des informations pertinentes pour le suivi de l'état de santé de la cellule.

La décomposition en modes empiriques est particulièrement bien adaptée à l'analyse de ce signal. Cette décomposition présente en outre l'avantage d'être relativement rapide et peu gourmande en termes de capacité de calcul.

L'évolution des énergies intrinsèques totales ou des densités spectrales intrinsèques totales au cours des différentes phases CV de la première vie de la cellule fournissent une base de données précieuse pour explorer l'historique de la cellule et estimer son état de santé. Bien que particulièrement synthétique (le volume des données à mémoriser reste relativement faible), cette base de données donne des indications très pertinentes sur l'état de santé de la cellule et sur la possibilité de la réutiliser en seconde vie.

Dans des modes particuliers de mise en œuvre, la méthode comporte en outre, pour chaque phase CV, une estimation d'une fiabilité statistique de la phase CV en fonction des composantes intrinsèques du signal de dérivée de courant de floating. La phase CV est filtrée si elle est jugée non fiable.

Dans des modes particuliers de mise en œuvre, la fiabilité statistique de la phase CV est estimée en fonction d'une entropie calculée pour une somme des composantes intrinsèques du signal de dérivée de courant de floating.

Dans des modes particuliers de mise en œuvre, la fiabilité statistique de la phase CV est estimée en comparant l'énergie intrinsèque totale avec un seuil d'énergie prédéterminé, ou avec les énergies intrinsèques totales calculées pour tout ou partie de phases CV précédentes.

Le filtrage des phases CV jugées non fiables statistiquement permet de limiter le nombre de valeurs d'incidence à mémoriser et par conséquent de limiter la taille du passeport numérique de la cellule. Cela permet également d'éviter d'introduire des valeurs aberrantes dans le passeport numérique de la cellule.

Dans des modes particuliers de mise en œuvre, la méthode comporte une étape de détection d'au moins une défaillance de la cellule au cours de sa première vie à partir des valeurs d'incidence mémorisées dans le fichier informatique formant le passeport numérique de la cellule.

Dans des modes particuliers de mise en œuvre, la détection de ladite au moins une défaillance comporte une comparaison de la valeur d'incidence avec un seuil d'incidence prédéterminé, pour une ou plusieurs phases CV consécutives.

Dans des modes particuliers de mise en œuvre, la détection de ladite au moins une défaillance comporte une comparaison d'une distance entre la valeur d'incidence et une valeur d'incidence moyenne avec un seuil de distance prédéterminé, pour une ou plusieurs phases CV consécutives.

La détection d'une ou plusieurs défaillances de la cellule au cours de sa première vie, à partir du passeport numérique de la cellule, peut notamment permettre d'estimer la possibilité ou non de réutiliser la cellule en seconde vie (par exemple en fonction du nombre et/ou de l'importance des défaillances observées).

Dans des modes particuliers de mise en œuvre, lorsqu'au moins une défaillance est détectée, la méthode comporte en outre une vérification si ladite au moins une défaillance détectée est liée à l'environnement dans lequel la cellule a évolué.

Dans des modes particuliers de mise en œuvre, la vérification si ladite au moins une défaillance détectée est liée à l'environnement comprend une comparaison, pour une période donnée, de valeurs d'incidence mémorisées pour ladite cellule pendant ladite période avec des valeurs d'incidence déterminées pour au moins une autre cellule soumise au même environnement pendant ladite période.

Dans des modes particuliers de mise en œuvre, la vérification si ladite au moins une défaillance détectée est liée à l'environnement comprend une comparaison, pour une période donnée, de mesures d'environnement effectuées et mémorisées pendant ladite période avec un seuil prédéterminé.

Il peut en effet être avantageux de savoir si certaines défaillances observées par la cellule au cours de sa première vie sont liées à l'environnement dans lequel la cellule a évolué. Des défaillances liées à l'environnement sont en effet généralement moins préjudiciables à la possibilité de réutiliser la batterie en seconde vie que des défaillances intrinsèques à la cellule (par exemple des défaillances liées à un défaut de fabrication ou à une dégradation précoce de la cellule).

Dans des modes particuliers de mise en œuvre, la méthode comporte une étape de détermination, à partir du passeport numérique de la cellule, si la cellule peut ou non être réutilisée pour une seconde vie.

Selon un deuxième aspect, il est proposé par la présente invention, un dispositif pour générer un « passeport numérique » d'une cellule d'une batterie Lithium-lon. Le passeport numérique prend la forme d'un fichier informatique comportant un ensemble de valeurs d'incidence représentatives d'un historique d'états de santé de la cellule au cours d'une première vie de la cellule. Le dispositif comporte :
- une mémoire adaptée pour mémoriser le fichier informatique,
- un système de gestion de batterie configuré pour fournir des mesures de courant effectuées au niveau de la cellule pendant une phase CV d'un cycle de charge CC-CV de la cellule,
- une unité de calcul connectée à la mémoire et au système de gestion de batterie, ladite unité de calcul étant configurée pour mettre en œuvre la méthode selon l'un quelconque des modes de mise en œuvre précédemment décrits.

### Présentation des figures

L'invention sera mieux comprise à la lecture de la description suivante, donnée à titre d'exemple nullement limitatif, et faite en se référant aux figures 1 à 14 qui représentent :
[Fig. 1] une représentation schématique des principales étapes d'un exemple de mise en œuvre de la méthode selon l'invention pour générer un passeport numérique d'une cellule de batterie Lithium-Ion,
[Fig. 2] une représentation schématique d'un mode particulier de mise en œuvre de l'étape de détermination d'une valeur d'incidence,
[Fig. 3] une représentation schématique d'un autre mode particulier de mise en œuvre de l'étape de détermination d'une valeur d'incidence,
[Fig. 4] un graphique représentant le courant circulant dans une cellule de batterie Lithium-Ion au cours de quatre cycles de charge CC-CV successifs,
[Fig. 5] un graphique représentant le courant de floating circulant dans une cellule de batterie Lithium-Ion au cours d'une phase CV d'un cycle de charge CC-CV de la cellule,
[Fig. 6] un graphique représentant la dérivée du courant de floating représenté à la figure 5,
[Fig. 7] un graphique représentant une décomposition en modes empiriques de la dérivée de courant de floating représenté sur la figure 6,
[Fig. 8] un premier exemple de représentation de valeurs d'incidence déterminées pour une cellule de batterie Lithium-Ion pendant une période donnée,
[Fig. 9] un deuxième exemple de représentation de valeurs d'incidence déterminées pour une cellule de batterie Lithium-Ion pendant une période donnée,
[Fig. 10] un troisième exemple de représentation de valeurs d'incidence déterminées pour une cellule de batterie Lithium-Ion pendant une période donnée,
[Fig. 11] un quatrième exemple de représentation de valeurs d'incidence déterminées pour une cellule de batterie Lithium-Ion pendant une période donnée,
[Fig. 12] un graphique représentant l'évolution au cours du temps de la valeur d'incidence d'une cellule de batterie, ainsi que l'évolution au cours du temps, pendant la même période, de la température subie par la cellule,
[Fig. 13] un graphique représentant un autre exemple de l'évolution au cours du temps de la valeur d'incidence d'une cellule de batterie, ainsi que l'évolution au cours du temps, pendant la même période, de la température subie par la cellule,
[Fig. 14] une représentation schématique d'un dispositif selon l'invention permettant de générer un passeport numérique pour une cellule d'une batterie Lithium-Ion.

Dans ces figures, des références identiques d'une figure à une autre désignent des éléments identiques ou analogues. Pour des raisons de clarté, les éléments représentés ne sont pas nécessairement à une même échelle, sauf mention contraire.

### Description détaillée de l'invention

Comme indiqué précédemment, la présente demande propose une méthode et un dispositif pour générer un « passeport numérique » d'une cellule d'une batterie Lithium-Ion.

Un cycle de charge d'une cellule de batterie Lithium-Ion comporte classiquement deux phases : une première phase de charge à courant constant, ou phase CC (pour « Constant Current » en anglais) et une deuxième phase de charge à tension constante, ou phase CV (pour « Constant Voltage » en anglais). On parle alors d'un cycle de charge CC-CV. Dans la présente invention, on s'intéresse au courant qui circule dans la cellule pendant la phase CV. Ce courant est généralement appelé « courant de floating ».

Bien que classiquement la première phase de charge (phase CC) s'effectue à courant constant, des schémas de charge plus élaborés peuvent exister durant cette première phase, avec une évolution du courant par exemple pour maximiser la vitesse de charge tout en restant dans le domaine de charge compatible avec l'accumulateur. La fin de la première phase de charge est alors marquée par l'atteinte d'un seuil de tension qui déclenche le basculement dans la seconde phase de charge à tension constante (phase CV). Par simplicité, on considèrera ces cas particuliers de première phase de charge comme également couverts par le vocable de charge CC-CV « courant constant - tension constante » utilisé dans cette demande.

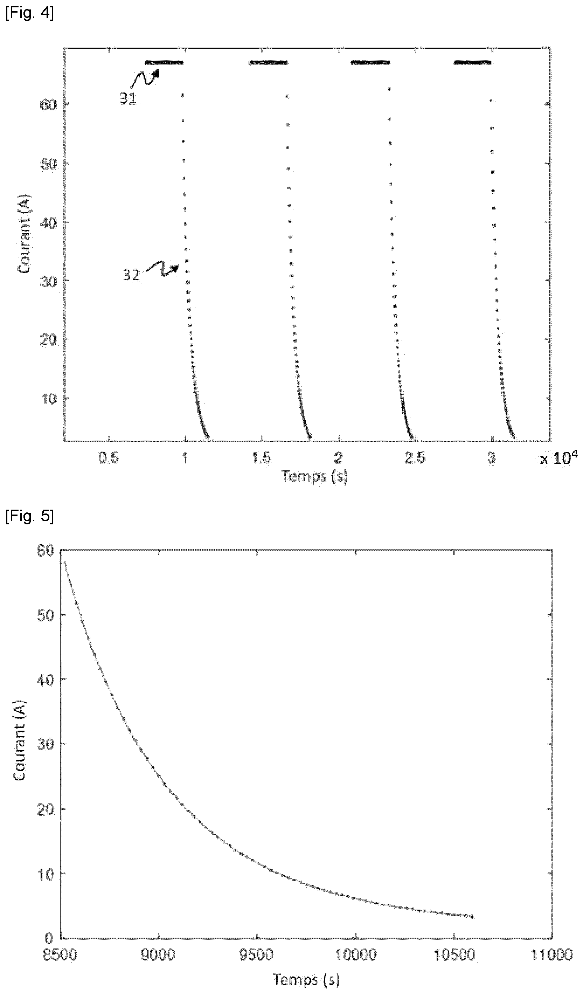

La figure 4 est un graphique représentant quatre cycles de charge CC-CV successifs d'une cellule de batterie Lithium-Ion. Le courant qui circule dans la cellule est représenté en ordonnée (en ampères) et le temps est représenté en abscisse (en secondes). Chaque cycle comporte une phase CC 31 et une phase CV 32. Tel qu'illustré sur le graphique de la figure 4, le courant qui circule dans la cellule pendant la phase CC 31 est sensiblement constant, et il présente une décroissance exponentielle pendant la phase CV 32. La figure 5 est un graphique représentant de façon plus détaillée la phase CV 32 d'un cycle de charge CC-CV de la cellule.

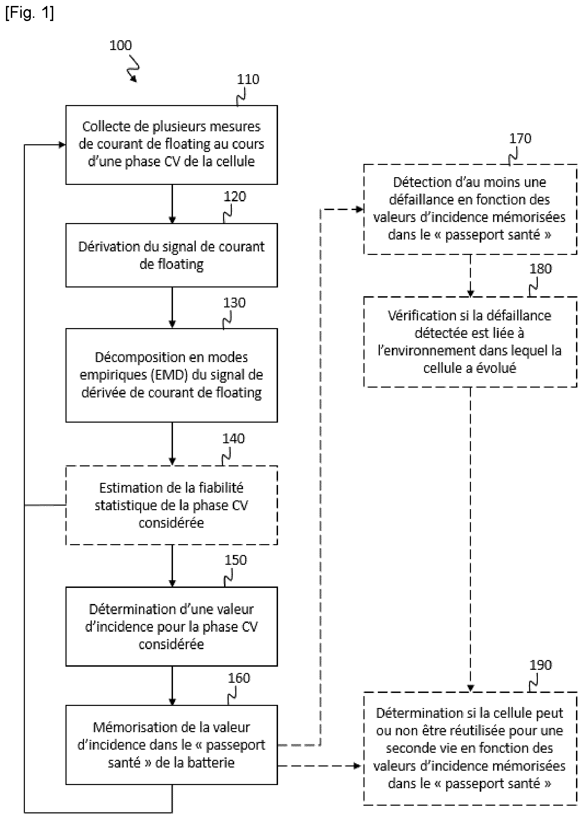

La figure 1 représente schématiquement les principales étapes d'un exemple de mise en œuvre d'une méthode 100 selon l'invention pour générer un passeport numérique d'une cellule d'une batterie Lithium-Ion.

Tel qu'illustré sur la figure 1, la méthode 100 comporte les étapes suivantes, pour chaque phase CV d'un ensemble de cycles de charge CC-CV au cours d'une première vie de la cellule :
- une collecte 110 de plusieurs mesures de courant de floating pendant la phase CV considérée,
- une dérivation 120 du courant de floating ainsi obtenu,
- une décomposition en modes empiriques 130 (EMD pour « Empirical Mode Decomposition » en anglais) de la dérivée du courant de floating,
- une détermination 150 d'une valeur d'incidence à partir des composantes intrinsèques obtenues par la décomposition EMD,
- une mémorisation 160 de la valeur d'incidence dans un fichier informatique.

Le fichier informatique ainsi obtenu forme un passeport numérique pour la cellule. Les valeurs d'incidence mémorisées dans ce passeport sont représentatives d'un historique d'états de santé de la cellule au cours de sa première vie.

Ces étapes peuvent être mises en œuvre pour la phase CV de tous les cycles de charge CC-CV subis par la cellule au cours de sa première vie. Rien n'empêcherait toutefois, dans une variante, de mettre en œuvre ces étapes uniquement pour un sous-ensemble de la totalité des cycles de charge, par exemple uniquement pour un cycle de charge sur deux.

Les mesures de courant de floating pendant la phase CV sont par exemple effectuées par un système de gestion de batterie (BMS pour « Battery Management System » en anglais) connecté à la cellule. Les mesures sont par exemple effectuées avec une fréquence d'acquisition comprise entre une et soixante secondes, pendant une durée d'acquisition de dix à soixante minutes. Rien n'empêcherait toutefois de faire les mesures avec une fréquence d'acquisition différente, et/ou pendant une durée d'acquisition différente. Il est avantageux d'utiliser un nombre de mesures compris entre trente et cinquante par phase CV (utiliser un plus grand nombre de mesures n'implique pas nécessairement une amélioration significative de la méthode, utiliser un nombre de mesures plus faible peut en revanche limiter les performances de la méthode). L'ensemble des mesures collectées pendant l'étape de collecte 110 forment un signal de « courant de floating ». Le graphique de la figure 5 représente un exemple de signal de courant de floating obtenu à l'étape de collecte 110.

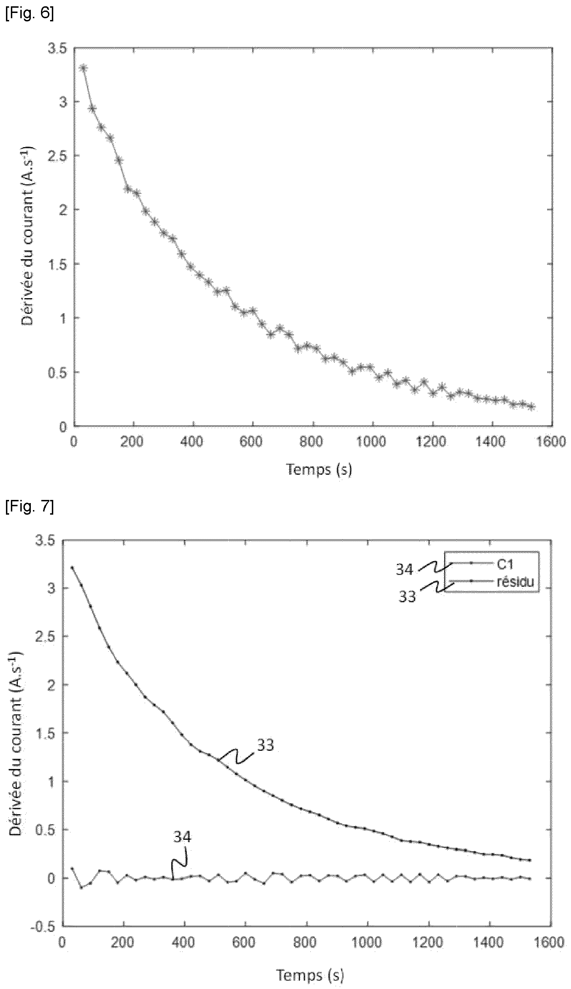

A l'étape de dérivation 120, le signal de courant de floating obtenu à l'étape 110 est dérivé pour obtenir un signal de dérivée de courant de floating. Le graphique de la figure 6 représente un exemple de signal de dérivée de courant de floating obtenu à l'étape de dérivation 120 (il s'agit de la dérivée du signal de courant de floating représenté sur le graphique de la figure 5).

A l'étape 130, le signal de dérivée de courant de floating est décomposé selon une décomposition en modes empiriques. Il convient de noter que le signal de courant de floating est généralement trop « lisse » et qu'il permet difficilement une décomposition en modes empiriques, c'est la raison pour laquelle on s'intéresse à sa dérivée, même si rien ne pouvait laisser présager au premier abord que ce signal de dérivée de courant de floating pouvait contenir des informations pertinentes sur l'état de santé de la cellule.

La décomposition en modes empiriques consiste à décomposer un signal sous la forme d'une somme de fonctions, de façon similaire à ce que fait la décomposition en série de Fourier ou la décomposition en ondelettes.

Une des particularités de la décomposition en modes empiriques est que la base de fonctions en lesquelles le signal est décomposé n'est pas connue a priori, mais elle est construite de façon adaptative en fonction des propriétés du signal.

La décomposition en modes empiriques correspond à la première partie de la transformée de Hilbert-Huang (HHT pour « Hilbert-Huang Transform » en anglais). La décomposition en modes empiriques consiste à décomposer un signal sous la forme d'une somme d'un signal résiduel et de fonctions de mode intrinsèque (IMF pour « Intrinsic Mode Function » en anglais). Dans la présente demande, ces fonctions de mode intrinsèque sont également appelées « composantes intrinsèques ».

Comme indiqué précédemment, les composantes intrinsèques ne sont pas définies analytiquement. Elles sont plutôt déterminées de façon adaptative en fonction des propriétés du signal.

Une composante intrinsèque (IMF) résultant d'une décomposition en modes empiriques (EMD) doit satisfaire aux exigences suivantes :
- le nombre d'extrema (c'est-à-dire la somme du nombre des maxima locaux et du nombre des minima locaux) et le nombre de passages par zéro de la composante intrinsèque doivent être égaux ou différer au maximum de un ;
- en tout point de la composante intrinsèque, la valeur moyenne de l'enveloppe définie par les maxima locaux et de l'enveloppe définie par les minima locaux est nulle.

Un signal s(t) décomposé par EMD peut alors s'écrire sous la forme : $s \left(t\right) = r \left(t\right) + {\sum }_{i = 1}^{N} {c}_{i} \left(t\right)$ Dans cette expression, r(t) correspond au signal résiduel, *N* est le nombre de composantes intrinsèques de la décomposition EMD, et *cᵢ* est la composante intrinsèque d'indice *i.* Chaque composante intrinsèque *cᵢ*(*t*) successive contient des oscillations de fréquence inférieure à celle de la précédente. Le signal résiduel correspond à une tendance générale du signal *s*(*t*)*.*

La décomposition en modes empiriques comporte une succession de processus de tamisage (« sifting process » en anglais). Le premier processus de tamisage prend en entrée le signal s(t) directement. Le processus de tamisage correspond à identifier tous les extrema locaux du signal d'entrée, et à relier les maxima locaux, respectivement les minima locaux, par une interpolation par splines cubiques, afin d'obtenir une enveloppe supérieure, respectivement une enveloppe inférieure. Une moyenne entre l'enveloppe supérieure et l'enveloppe inférieure peut alors être calculée et soustraite au signal d'entrée. Si le signal intermédiaire obtenu (soustraction du signal d'entrée avec la moyenne des enveloppes supérieure et inférieure) n'est pas une composante intrinsèque, le processus de tamisage est réitéré sur le signal intermédiaire (qui devient donc le signal d'entrée d'un nouveau processus de tamisage) jusqu'à obtenir une composante intrinsèque. Les processus de tamisage sont répétés jusqu'à obtenir la dernière composante intrinsèque, c'est-à-dire par exemple jusqu'à ce que le signal intermédiaire devienne monotone ou qu'il ne comporte plus qu'un seul extremum local. Le signal restant correspond alors au signal résiduel r(t).

Un critère d'arrêt peut être défini pour le processus de tamisage. Par exemple le critère d'arrêt est satisfait si l'écart-type entre les résultats de deux processus de tamisage successifs est inférieur ou égale à un seuil d'arrêt prédéterminé. Le seuil d'arrêt peut typiquement être compris entre 0.2 et 0.3.

Le document « The empirical mode decomposition and the Hilbert spectrum for non-linear and non-stationary time series analysis », Norden E. Huang et al., Proc. R. Soc. Lond. A (1998) 454, p. 903-995, décrit de façon détaillée la décomposition en modes empiriques, notamment dans ses sections 4 et 5.

Des algorithmes de décomposition en modes empiriques sont disponibles dans des bibliothèques de programmation, par exemple en langage MATLAB ou Python.

Le graphique de la figure 7 représente un exemple de décomposition en modes empiriques du signal de dérivée de courant de floating représenté sur la figure 6. Dans l'exemple considéré et illustré à la figure 7, la décomposition en modes empiriques a donné une seule composante intrinsèque 34 (*c*₁) et un signal résiduel 33. Il convient de noter que, dans d'autres exemples, un nombre plus important de composantes intrinsèques peut être obtenu. Le nombre de composantes intrinsèques reste toutefois généralement inférieur à cinq. Il est avantageux de paramétrer le seuil d'arrêt à un niveau relativement bas, de l'ordre de 0.2, pour extraire un maximum d'information du signal de dérivée de courant de floating. Utiliser un seuil d'arrêt plus faible impose des temps de calcul particulièrement importants.

Les composantes intrinsèques obtenues à l'étape 130 sont alors utilisées à l'étape 150 pour déterminer une valeur d'incidence représentative de l'état de santé de la cellule pour la phase CV considérée.

Différentes méthodes peuvent être envisagées pour déterminer la valeur d'incidence associée à la phase CV considérée.

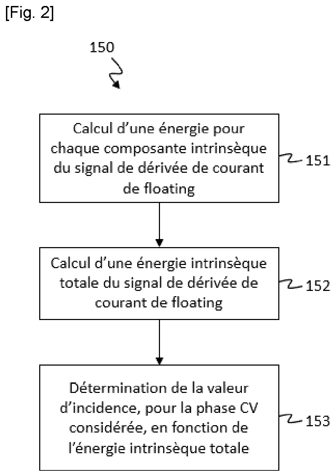

Selon un premier exemple, et tel qu'illustré sur la figure 2, la détermination 150 de la valeur d'incidence peut comporter :
- un calcul 151 d'une énergie pour chaque composante intrinsèque,
- un calcul 152 d'une énergie intrinsèque totale égale à la somme des énergies des composantes intrinsèques, et
- une détermination 153 de la valeur d'incidence en fonction de l'énergie intrinsèque totale ainsi calculée.

L'énergie *Eᵢ* d'une composante intrinsèque *cᵢ* correspond par exemple à l'intégrale du carré de l'amplitude de la composante intrinsèque *cᵢ* sur la durée d'acquisition de la phase CV considérée : ${E}_{i} = \int {\left|{c}_{i}\left(t\right)\right|}^{2} dt$

L'énergie intrinsèque totale E de la phase CV considérée peut alors s'écrire sous la forme : $E = {\sum }_{i = 1}^{N} {E}_{i}$

Il convient de noter que rien n'empêcherait, dans une variante, de calculer l'énergie intrinsèque totale E en sommant les énergies d'un sous-ensemble seulement des composantes intrinsèques obtenues par la décomposition EMD (par exemple en considérant seulement un nombre maximum prédéfini des premières composantes intrinsèques obtenues par la décomposition EMD).

La valeur d'incidence de la phase CV considérée peut alors correspondre à l'énergie intrinsèque totale de la phase CV, ou à une valeur moyenne de l'énergie intrinsèque totale pour tout ou partie des énergies intrinsèques totales calculées pour des phases CV précédentes.

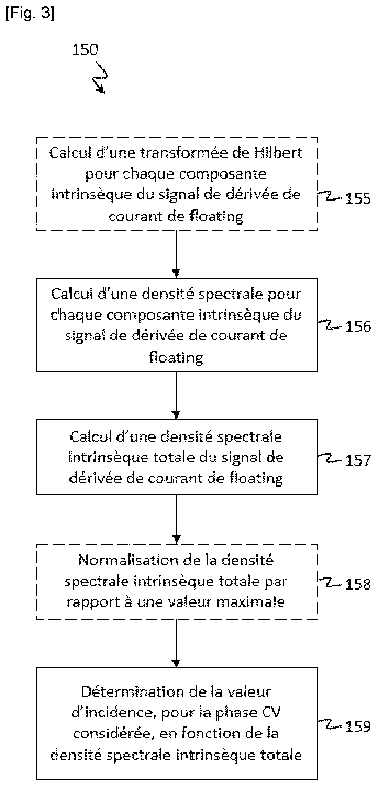

Selon un deuxième exemple, et tel qu'illustré sur la figure 3, la détermination 150 de la valeur d'incidence peut comporter :
- un calcul 156 d'une densité spectrale pour chaque composante intrinsèque,
- un calcul 157 d'une densité spectrale intrinsèque totale égale à la somme des densités spectrales des composantes intrinsèques (ou éventuellement égale à la somme des densités spectrales des composantes intrinsèques d'un sous-ensemble seulement des composantes intrinsèques), et
- une détermination 159 de la valeur d'incidence en fonction de la densité spectrale intrinsèque totale ainsi calculée.

Par exemple, la valeur d'incidence de la phase CV considérée peut correspondre à l'aire de la densité spectrale intrinsèque totale de la phase CV, ou à une valeur moyenne de l'aire de la densité spectrale intrinsèque totale pour tout ou partie des énergies intrinsèques totales calculées pour des phase CV précédentes. La valeur d'incidence pourrait aussi correspondre à un ensemble d'échantillons de la densité spectrale intrinsèque totale.

Rien n'empêcherait toutefois de déterminer la valeur d'incidence d'une phase CV en combinant l'énergie intrinsèque totale et la densité spectrale intrinsèque totale. Par exemple, la valeur d'incidence peut correspondre à un couple de valeurs comportant l'énergie intrinsèque totale et l'aire (ou un ensemble d'échantillons) de la densité spectrale intrinsèque totale de la phase CV considérée.

Les densités spectrales des différentes composantes intrinsèques peuvent notamment être calculées par la méthode de Welch. Rien n'empêcherait toutefois d'utiliser d'autres méthodes d'estimation de densité spectrale, comme par exemple les méthodes de Bartlett ou de Blackman-Tukey.

La densité spectrale de chaque composante intrinsèque peut optionnellement être calculée à partir d'une transformée de Hilbert de la composante intrinsèque. Dans ce but, et tel qu'illustré sur la figure 3, l'étape de détermination 150 de la valeur d'incidence comporte une étape supplémentaire de calcul 155 d'une transformée de Hilbert de chaque composante intrinsèque du signal de dérivée de courant de floating, préalablement à l'étape de calcul 156 des densités spectrales des composantes intrinsèques.

La transformation de Hilbert permet d'étendre un signal réel dans le domaine complexe. Le signal transformé présente alors des réponses d'amplitude nulle aux fréquences nulles. Cela permet d'éviter des artéfacts lors de l'exploitation des informations contenues dans le signal traité. La transformation de Hilbert permet ainsi d'optimiser le calcul de densité spectrale.

Des algorithmes permettant ces calculs de transformation de Hilbert et d'estimation de densité spectrale sont disponibles dans des bibliothèques de programmation, par exemple en MATLAB ou en Python.

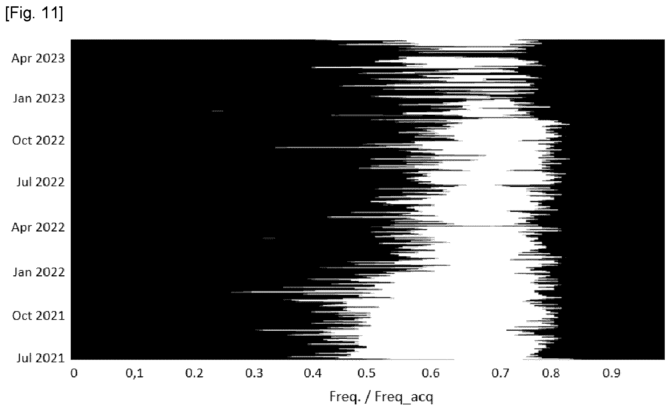

**En** outre, et tel qu'illustré sur la figure 3 par l'étape optionnelle 158, la densité spectrale intrinsèque totale peut être normalisée, par exemple par rapport à une valeur maximale de la densité spectrale intrinsèque totale. Il est particulièrement avantageux de faire cette normalisation lorsque l'on souhaite « cartographier » la densité spectrale intrinsèque totale et comparer les différentes cartographies obtenues pour différentes phases CV. Une cartographie de la densité spectrale intrinsèque totale correspond à une représentation de l'amplitude, de la position spectrale et de la largeur spectrale des différents pics de la densité spectrale intrinsèque totale. Cette cartographie peut être réalisée à partir d'un ensemble d'échantillons de la densité spectrale intrinsèque totale. La figure 11 est un exemple de cartographie des densités spectrales intrinsèques totales calculées pour différentes dates (ce graphique sera décrit en détail ultérieurement).

Tel qu'illustré sur la figure 1, la valeur d'incidence déterminée pour chaque phase CV à l'étape 150 est mémorisée, à l'étape 160, dans le fichier informatique formant le passeport numérique de la cellule. Dans ce fichier informatique, chaque valeur d'incidence est associée à une information sur l'instant d'occurrence de la phase CV à laquelle elle correspond. Cette information peut par exemple correspondre à une date d'occurrence, avec le jour et éventuellement l'heure à laquelle la phase CV a eu lieu. Cette information pourrait aussi tout simplement correspondre à un numéro de phase CV (ce numéro étant incrémenté à chaque nouvelle phase CV observée par la cellule au cours de sa première vie).

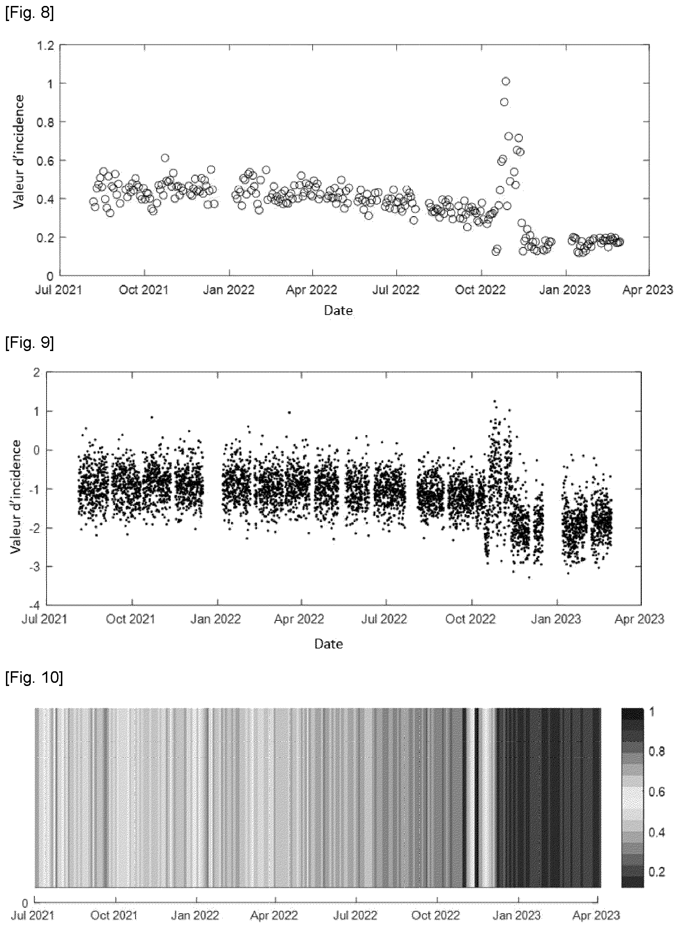

Les figures 8 et 9 représentent des exemples de valeurs d'incidence, associées aux dates des phases CV pour lesquelles elles ont été déterminées, pour une cellule de batterie Lithium-Ion pendant une période donnée (entre juillet 2021 et avril 2023).

Sur le graphique de la figure 8, chaque valeur d'incidence correspond à une moyenne des énergies intrinsèques totales calculées pour vingt phases CV consécutives.

Sur le graphique de la figure 9, chaque valeur d'incidence correspond à l'aire de la densité spectrale intrinsèque totale calculée pour chacune des phases CV successivement subies par la cellule pendant la période considérée.

Le nombre de valeurs d'incidence représentées sur figure 8 est donc inférieure au nombre de valeurs d'incidence représentées sur la figure 9 (sur la figure 8, une valeur d'incidence correspond à vingt phases CV consécutives tandis que sur la figure 9, une valeur d'incidence correspond à une seule phase CV).

L'ensemble des valeurs d'incidence représentées sur les figures 8 et 9 peuvent correspondre à un passeport numérique de la cellule. Le volume de données nécessaire pour former ce passeport est relativement faible, par exemple de l'ordre de quelques kilooctets à quelques dizaines de kilooctets.

Les figures 10 et 11 illustrent d'autres exemple de représentation des valeurs d'incidence. Tel qu'illustré sur la figure 10, il est possible de représenter les valeurs d'incidence sous la forme d'une bande graphique. L'axe longitudinal de la bande représente l'évolution du temps. Un code couleur représente la valeur d'incidence à une date donnée (par exemple la valeur de l'énergie intrinsèque totale, ou la valeur de l'aire de la densité spectrale intrinsèque totale).

Tel qu'illustré sur la figure 11, il est aussi possible de représenter une cartographie des densités spectrales intrinsèques totales normalisées. Le temps est représenté en ordonnée. L'axe des abscisses représente le rapport entre la fréquence et la fréquence d'acquisition. Un code couleur peut permettre de représenter l'amplitude d'un pic de la densité spectrale à une fréquence donnée. Cela permet ainsi de cartographier l'amplitude, la position spectrale et la largeur spectrale des différents pics de la densité spectrale intrinsèque totale normalisée. Cette cartographie peut être réalisée à partir d'un ensemble d'échantillons de la densité spectrale intrinsèque totale normalisée. Lorsque le passeport numérique d'une cellule mémorise, pour chaque phase CV considérée, des échantillons de la densité spectrale intrinsèque totale normalisée, le volume de données nécessaires devient plus important, par exemple quelques centaines de kilooctets à quelques mégaoctets.

Tel qu'illustré sur la figure 1, la méthode 100 selon l'invention peut également comporter une étape optionnelle d'estimation 140 de fiabilité statistique d'une phase CV, et un filtrage de la phase CV si celle-ci est jugée non fiable (on peut d'ailleurs voir dans les figures 8 et 9 que pour certaines dates des valeurs d'incidence n'ont pas été déterminées ni mémorisées).

Ce filtrage des phases CV jugées non fiables permet de limiter le nombre de valeurs d'incidence à mémoriser, et par conséquent de limiter la taille du passeport numérique de la cellule. Cela permet également d'éviter d'introduire des valeurs aberrantes dans le passeport numérique de la cellule.

La fiabilité statistique d'une phase CV est estimée en fonction des composantes intrinsèques du signal de dérivée de courant de floating obtenues pour la phase CV.

Selon un premier exemple, la fiabilité statistique de la phase CV est estimée en fonction d'une entropie calculée pour une somme des composantes intrinsèques du signal de dérivée de courant de floating (par exemple pour la somme de l'ensemble des composantes intrinsèques obtenues par la décomposition EMD, ou pour la somme d'un nombre maximum prédéfini des premières composantes intrinsèques obtenues par la décomposition EMD). Différentes méthodes de calcul d'entropie peuvent être envisagés, comme par exemple un calcul d'entropie de Shannon, ou un calcul d'entropie de Kolmogorov. Par exemple, les phases CV pour lesquelles l'entropie calculée est trop faible (inférieure à un seuil prédéterminé) sont filtrées. Un seuil d'entropie de Shannon compris entre 0.25 et 0.5 peut notamment être envisagé.

Selon un deuxième exemple, la fiabilité statistique de la phase CV est estimée en comparant l'énergie intrinsèque totale calculée pour la phase CV avec un seuil d'énergie prédéterminé. Par exemple, les phases CV qui présentent une valeur d'énergie intrinsèque totale aberrante (supérieure au seuil d'énergie) sont filtrées.

Selon encore un autre exemple, la fiabilité statistique de la phase CV est estimée en comparant l'énergie intrinsèque totale calculée pour la phase CV avec les énergies intrinsèques totales calculées pour tout ou partie de phases CV précédentes (par exemple les énergies intrinsèques totales peuvent être comparées entre elles, ou bien l'énergie intrinsèque totale de la phase CV courante peut être comparée à une valeur moyenne d'énergies intrinsèques totales de phases CV précédentes). Différents tests statistiques peuvent être envisagés dans ce but (test de Pierce, test de Pierson, etc.).

Le passeport numérique obtenu par la méthode 100 décrite ci-avant peut notamment être utilisé pour déterminer si la cellule peut ou non être recyclée pour une seconde vie.

Il est par exemple possible de détecter, à partir du passeport numérique, si la cellule a subi une ou plusieurs défaillances au cours de sa première vie. La possibilité ou non de réutiliser la cellule en seconde vie peut alors être estimée en fonction du nombre et/ou de l'importance des défaillances observées par la cellule au cours de sa première vie.

Dans ce but, et tel qu'illustré sur la figure 1, la méthode 100 peut comporter une étape optionnelle de détection 170 d'une ou plusieurs défaillances de la cellule au cours de sa première vie, à partir des valeurs d'incidence mémorisées dans le fichier informatique formant le passeport numérique de la cellule.

Selon un premier exemple, la détection d'une défaillance peut être mise en œuvre en comparant la valeur d'incidence avec un seuil d'incidence prédéterminé, pour une ou plusieurs phases CV consécutives.

D'autres critères de détection d'une défaillance pourraient toutefois être envisagés. Par exemple, la détection d'une défaillance pourrait être mise en œuvre en comparant une distance entre une valeur d'incidence et une valeur d'incidence moyenne avec un seuil de distance prédéterminé, pour une ou plusieurs phases CV consécutives.

A titre d'exemple, les figures 8 et 9 mettent en évidence un comportement anormal de la cellule au mois de novembre 2022. **En** effet, les valeurs d'énergie intrinsèque totale (figure 8) et d'aire de densité spectrale intrinsèque totale (figure 9) sont particulièrement élevées au cours du mois de novembre 2022. Cela met en évidence une éventuelle défaillance de la cellule à cette période. **En** outre, on peut observer que les valeurs d'incidence prennent ensuite des valeurs plus basses par rapport aux valeurs observées avant le mois de novembre 2022. Cela met en évidence un vieillissement prématuré (ou précoce) de la cellule suite à la défaillance du mois de novembre 2022.

Le comportement anormal de la cellule au mois de novembre 2022 peut également être observé sur les représentations graphiques des figures 10 et 11. Sur la figure 10, on peut en effet observer un code couleur particulièrement foncé sur la bande graphique à partir du mois de novembre 2022. Sur la figure 11, on peut observer un changement de la position et de la largeur du pic principal de la densité spectrale à partir du mois de novembre 2022.

Il peut être avantageux de savoir si certaines défaillances observées par la cellule au cours de sa première vie sont liées à l'environnement dans lequel la cellule a évolué. Des défaillances liées à l'environnement sont en effet généralement moins préjudiciables à la possibilité de réutiliser la batterie en seconde vie que des défaillances intrinsèques à la cellule (par exemple des défaillances liées à un défaut de fabrication ou à une dégradation précoce de la cellule).

Dans ce but, et tel qu'illustré sur la figure 1, la méthode 100 peut comporter une étape optionnelle de vérification 180 si une défaillance détectée est liée à l'environnement dans lequel la cellule a évolué.

Cette vérification 180 peut notamment comprendre une comparaison, pour une période donnée, de valeurs d'incidence mémorisées pour la cellule pendant ladite période avec des valeurs d'incidence déterminées et mémorisées pour au moins une autre cellule soumise au même environnement pendant ladite période. Si les valeurs d'incidence observées pour une ou plusieurs autres cellules soumises au même environnement mettent en évidence une évolution anormale similaire pendant une période donnée, alors il est fortement probable que ce comportement anormal soit lié à l'environnement (par exemple à cause d'une augmentation exceptionnelle de la température subie par les différentes cellules pendant cette période).

Dans une variante, la vérification 180 peut comprendre une comparaison, pour une période donnée, de mesures d'environnement effectuées et mémorisées pendant ladite période avec un seuil prédéterminé. Il peut s'agir par exemple de l'enregistrement de mesures de la température à laquelle la cellule a été exposée.

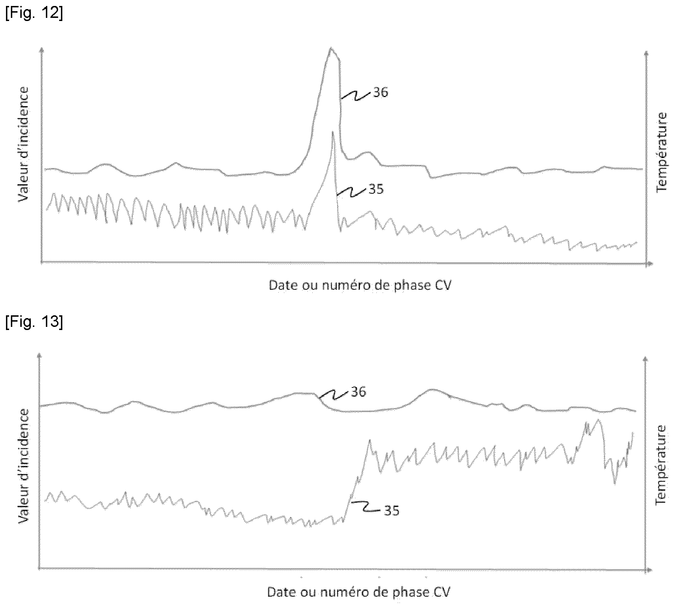

A titre d'exemple, les figures 12 et 13 illustrent l'évolution au cours du temps de la valeur d'incidence d'une cellule de batterie (courbe 35) ainsi que l'évolution au cours du temps, pendant la même période, de la température subie par la cellule (courbe 36).

Dans l'exemple illustré à la figure 12, la défaillance mise en évidence par le pic de valeur d'incidence est très probablement liée à l'environnement car un pic similaire est observé au même moment pour la température subie par la cellule.

**En** revanche, dans l'exemple illustré à la figure 13, il n'y a pas de corrélation particulière entre l'évolution de la valeur d'incidence et l'évolution de la température. La défaillance mise en évidence par l'augmentation brutale des valeurs d'incidence ne semble donc pas liée à l'environnement.

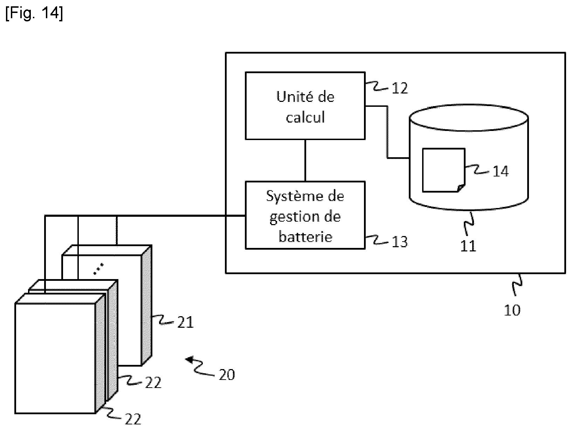

La figure 14 représente schématiquement un dispositif 10 pour générer un passeport numérique d'une cellule 21 d'une batterie 22 Lithium-Ion. Le dispositif 10 comporte notamment une mémoire 11, un système de gestion 13 de batterie et une unité de calcul 12 connectée à la mémoire 11 et au système de gestion 13 de batterie.

Le passeport numérique correspond à un fichier informatique 14 sauvegardé dans la mémoire 11. Ce fichier informatique 14 comporte un ensemble de valeurs d'incidence représentatives d'un historique d'états de santé de la cellule 21 au cours d'une première vie de la cellule 21.

Le système de gestion de batterie est configuré pour fournir des mesures de courant effectuées au niveau de la cellule 21 pendant une phase CV d'un cycle de charge CC-CV.

L'unité de calcul 12 est configurée pour mettre en œuvre la méthode 100 selon l'un quelconque des modes de mise en œuvre décrits ci-avant.

Le dispositif 10 peut en outre comporter un capteur configuré pour mesurer l'environnement (par exemple un capteur de température).

Le système de gestion 13 de batterie peut également être configuré pour fournir des mesures de courant de floating d'une ou plusieurs autres cellules 22 soumises à un même environnement que la cellule 21.

La description ci-avant illustre clairement que, par ses différentes caractéristiques et leurs avantages, la présente invention atteint les objectifs fixés. En particulier, l'évolution des valeurs d'incidence observées pour les différentes phases CV de la cellule fournissent une base de données particulièrement pertinente pour estimer son état de santé et la possibilité de la réutiliser en seconde vie.

Il est à noter que, pour le remploi ou le reconditionnement de différentes cellules de batterie en seconde vie, il est envisageable d'apparier entre elles des cellules dont le passeport numérique présente des similitudes. Par exemple, lorsque la valeur d'incidence est déterminée sous la forme d'une densité spectrale, il est possible d'apparier entre elles des cellules présentant des similarités spectrales. **En** appariant des cellules de même profil spectral, une plus grande homogénéité de la batterie peut être attendu en seconde vie.

De façon avantageuse, le volume des données à mémoriser pour former le passeport numérique de la cellule reste particulièrement faible. Ce passeport numérique peut donc facilement être échangé entre différentes entités intéressées par l'état de santé de la cellule.

## Revendications

1. Méthode (100) pour générer un « passeport numérique » d'une cellule (21) d'une batterie (20) Lithium-Ion, ledit passeport numérique prenant la forme d'un fichier informatique (14) comportant un ensemble de valeurs d'incidence représentatives d'un historique d'états de santé de la cellule (21) au cours d'une première vie de la cellule (21), la méthode comportant, pour chaque phase « tension constante », ou phase CV (32), d'un ensemble de cycles de charge « courant constant - tension constante », ou cycles de charge CC-CV, de la cellule (21) au cours de sa première vie :
- une collecte (110) d'une pluralité de mesures de courant effectuées au niveau de la cellule (21) pendant la phase CV considérée, ladite pluralité de mesures formant un signal de « courant de floating »,
- une dérivation (120) du signal de courant de floating pour obtenir un signal de dérivée de courant de floating,
- une décomposition en modes empiriques (130) du signal de dérivée de courant de floating afin d'en obtenir une représentation sous la forme d'une somme d'un signal résiduel et d'une ou plusieurs composantes intrinsèques,
- une détermination (150) d'une valeur d'incidence représentative d'un état de santé de la cellule (21), pour la phase CV considérée, à partir des composantes intrinsèques ainsi obtenues,
- une mémorisation (160) dans le fichier informatique (14) de la valeur d'incidence déterminée associée à une information sur l'instant d'occurrence de la phase CV considérée.

2. Méthode (100) selon la revendication 1, dans laquelle la détermination (150) de la valeur d'incidence, pour la phase CV considérée, comprend :
- un calcul (151) d'une énergie pour chaque composante intrinsèque,
- un calcul (152) d'une énergie intrinsèque totale égale à une somme des énergies des composantes intrinsèques,
- une détermination (153) de la valeur d'incidence, pour la phase CV considérée, en fonction de l'énergie intrinsèque totale ainsi calculée.

3. Méthode (100) selon l'une quelconque des revendications 1 à 2, dans laquelle la détermination (150) de la valeur d'incidence, pour la phase CV considérée, comprend :
- un calcul (156) d'une densité spectrale pour chaque composante intrinsèque,
- un calcul (157) d'une densité spectrale intrinsèque totale égale à une somme des densités spectrales des différentes composantes intrinsèques,
- une détermination (159) de la valeur d'incidence, pour la phase CV considérée, en fonction de la densité spectrale intrinsèque totale ainsi calculée.

4. Méthode (100) selon la revendication 3 dans laquelle la densité spectrale intrinsèque totale est normalisée par rapport à une valeur maximale de la densité spectrale intrinsèque totale.

5. Méthode (100) selon l'une quelconque des revendications 3 à 4, dans laquelle, pour chaque composante intrinsèque, la densité spectrale de la composante intrinsèque est calculée à partir d'une transformée de Hilbert de la composante intrinsèque.

6. Méthode (100) selon l'une quelconque des revendications 1 à 5, comportant en outre, pour chaque phase CV, une estimation (140) d'une fiabilité statistique de la phase CV, en fonction des composantes intrinsèques du signal de dérivée de courant de floating, et un filtrage de la phase CV si celle-ci est jugée non fiable.

7. Méthode (100) selon la revendication 6, dans laquelle la fiabilité statistique de la phase CV est estimée en fonction d'une entropie calculée pour une somme des composantes intrinsèques du signal de dérivée de courant de floating.

8. Méthode (100) selon la revendication 6, en combinaison avec la revendication 2, dans laquelle la fiabilité statistique de la phase CV est estimée en comparant l'énergie intrinsèque totale avec un seuil d'énergie prédéterminé, ou avec les énergies intrinsèques totales calculées pour tout ou partie de phases CV précédentes.

9. Méthode (100) selon l'une quelconque des revendications 1 à 8, comportant une étape de détection (170) d'au moins une défaillance de la cellule (21) au cours de sa première vie à partir des valeurs d'incidence mémorisées dans le fichier informatique (14) formant le passeport numérique de la cellule (21).

10. Méthode (100) selon la revendication 9, dans laquelle la détection (170) de ladite au moins une défaillance comporte une comparaison de la valeur d'incidence avec un seuil d'incidence prédéterminé, pour une ou plusieurs phases CV consécutives.

11. Méthode (100) selon l'une quelconque des revendications 9 à 10, dans laquelle la détection (170) de ladite au moins une défaillance comporte une comparaison d'une distance entre la valeur d'incidence et une valeur d'incidence moyenne avec un seuil de distance prédéterminé, pour une ou plusieurs phases CV consécutives.

12. Méthode (100) selon l'une quelconque des revendications 9 à 11 dans laquelle, lorsqu'au moins une défaillance est détectée, la méthode comporte en outre une vérification (180) si ladite au moins une défaillance détectée est liée à l'environnement dans lequel la cellule a évolué.

13. Méthode (100) selon la revendication 12, dans laquelle la vérification (180) si ladite au moins une défaillance détectée est liée à l'environnement comprend une comparaison, pour une période donnée, de valeurs d'incidence mémorisées pour ladite cellule (21) pendant ladite période avec des valeurs d'incidence déterminées pour au moins une autre cellule (22) soumise au même environnement pendant ladite période.

14. Méthode (100) selon l'une quelconque des revendications 12 à 13, dans laquelle la vérification (180) si ladite au moins une défaillance détectée est liée à l'environnement comprend une comparaison, pour une période donnée, de mesures d'environnement effectuées et mémorisées pendant ladite période avec un seuil prédéterminé.

15. Méthode (100) selon l'une quelconque des revendications 1 à 14, comportant une étape de détermination (190), à partir du passeport numérique de la cellule (21), si la cellule (21) peut ou non être réutilisée pour une seconde vie.

16. Dispositif (10) pour générer un « passeport numérique » d'une cellule (21) d'une batterie (22) Lithium-Ion, ledit passeport numérique prenant la forme d'un fichier informatique (14) comportant un ensemble de valeurs d'incidence représentatives d'un historique d'états de santé de la cellule (21) au cours d'une première vie de la cellule (21), ledit dispositif (10) comportant :
- une mémoire (11) adaptée pour mémoriser le fichier informatique (14),
- un système de gestion (13) de batterie configuré pour fournir des mesures de courant effectuées au niveau de la cellule (21) pendant une phase CV d'un cycle de charge CC-CV de la cellule (21),
- une unité de calcul (12) connectée à la mémoire (11) et au système de gestion (13) de batterie, ladite unité de calcul (12) étant configurée pour mettre en œuvre la méthode (100) selon l'une quelconque des revendications 1 à 15.

## Patentansprüche

1. Verfahren (100) zum Erzeugen eines "digitalen Passes" einer Zelle (21) einer Lithium-Ionen-Batterie (20), wobei der digitale Pass die Form einer Computerdatei (14) annimmt, die eine Reihe von Inzidenzwerten aufweist, die für einen Verlauf von Gesundheitszuständen der Zelle (21) während eines ersten Lebens der Zelle (21) repräsentativ sind, wobei das Verfahren für jede "Konstantspannungs"-Phase oder CV-Phase (32) eine Reihe von "Konstantstrom-Konstantspannungs"-Ladezyklen oder CC-CV-Ladezyklen der Zelle (21) während ihres ersten Lebens aufweist:
- Sammeln (110) einer Vielzahl von an der Zelle (21) während der betrachteten CV-Phase durchgeführten Strommessungen, wobei die Vielzahl von Messungen ein "Floating-Strom"-Signal bildet,
- Abzweigen (120) des Floating-Stromsignals, um ein Floating-Strom-Derivatsignal zu erhalten,
- empirisches Aufschlüsseln (130) des Floating-Strom-Derivatsignals, um eine Darstellung in Form einer Summe aus einem Restsignal und einer oder mehreren intrinsischen Komponenten zu erhalten,
- Bestimmen (150) eines Inzidenzwerts, der für einen Gesundheitszustand der Zelle (21) repräsentativ ist, für die betrachtete CV-Phase aus den so erhaltenen intrinsischen Komponenten,
- Speichern (160) in der Computerdatei (14) des bestimmten Inzidenzwerts in Verbindung mit einer Information über den Zeitpunkt des Auftretens der betrachteten CV-Phase.

2. Verfahren (100) nach Anspruch 1, wobei das Bestimmen (150) des Inzidenzwerts für die betrachtete CV-Phase umfasst:
- Berechnen (151) einer Energie für jede intrinsische Komponente,
- Berechnen (152) einer gesamten intrinsischen Energie, die einer Summe der Energien der intrinsischen Komponenten entspricht,
- Bestimmen (153) des Inzidenzwerts für die betrachtete CV-Phase in Abhängigkeit von der so berechneten gesamten intrinsischen Energie.

3. Verfahren (100) nach einem der Ansprüche 1 bis 2, wobei das Bestimmen (150) des Inzidenzwerts für die betrachtete CV-Phase umfasst:
- Berechnen (156) einer spektralen Dichte für jede intrinsische Komponente,
- Berechnen (157) einer gesamten intrinsischen spektralen Dichte, die einer Summe der spektralen Dichten der verschiedenen intrinsischen Komponenten entspricht,
- Bestimmen (159) des Inzidenzwerts für die betrachtete CV-Phase in Abhängigkeit von der so berechneten gesamten intrinsischen spektralen Dichte.

4. Verfahren (100) nach Anspruch 3, wobei die gesamte intrinsische spektrale Dichte in Bezug auf einen Maximalwert der gesamten intrinsischen spektralen Dichte normalisiert ist.

5. Verfahren (100) nach einem der Ansprüche 3 bis 4, wobei für jede intrinsische Komponente die spektrale Dichte der intrinsischen Komponente aus einer Hilbert-Transformation der intrinsischen Komponente berechnet wird.

6. Verfahren (100) nach einem der Ansprüche 1 bis 5, das weiter für jede CV-Phase ein Schätzen (140) einer statistischen Zuverlässigkeit der CV-Phase in Abhängigkeit von den intrinsischen Komponenten des Floating-Strom-Ableitungssignals und ein Filtern der CV-Phase aufweist, wenn diese als unzuverlässig erachtet wird.

7. Verfahren (100) nach Anspruch 6, wobei die statistische Zuverlässigkeit der Phase CV in Abhängigkeit von einer berechneten Entropie für eine Summe der intrinsischen Komponenten des Floating-Strom-Derivatsignals geschätzt wird.

8. Verfahren (100) nach Anspruch 6, in Kombination mit Anspruch 2, wobei die statistische Zuverlässigkeit der CV-Phase durch Vergleich der gesamten intrinsischen Energie mit einem vorbestimmten Energieschwellenwert oder mit den berechneten gesamten intrinsischen Energien für alle oder einen Teil der vorherigen CV-Phasen geschätzt wird.

9. Verfahren (100) nach einem der Ansprüche 1 bis 8, das einen Schritt zum Erkennen (170) mindestens eines Ausfalls der Zelle (21) während ihres ersten Lebens anhand der in der Computerdatei (14), die den digitalen Pass der Zelle (21) bildet, gespeicherten Inzidenzwerte aufweist.

10. Verfahren (100) nach Anspruch 9, wobei das Erkennen (170) des mindestens einen Fehlers einen Vergleich des Inzidenzwerts mit einem vorbestimmten Inzidenzschwellenwert für eine oder mehrere aufeinanderfolgende CV-Phasen aufweist.

11. Verfahren (100) nach einem der Ansprüche 9 bis 10, wobei das Erkennen (170) des mindestens einen Fehlers einen Vergleich eines Abstands zwischen dem Inzidenzwert und einem mittleren Inzidenzwert mit einem vorbestimmten Abstandsschwellenwert für eine oder mehrere aufeinanderfolgende CV-Phasen aufweist.

12. Verfahren (100) nach einem der Ansprüche 9 bis 11, wobei das Verfahren, wenn mindestens ein Fehler erkannt wird, weiter eine Überprüfung (180) aufweist, ob der mindestens eine erkannte Fehler mit der Umgebung zusammenhängt, in der sich die Zelle entwickelt hat.

13. Verfahren (100) nach Anspruch 12, wobei das Überprüfen (180), ob der mindestens eine erkannte Fehler mit der Umgebung zusammenhängt, einen Vergleich, für einen bestimmten Zeitraum, von für die Zelle (21) während des Zeitraums gespeicherten Inzidenzwerten mit bestimmten Inzidenzwerten für mindestens eine andere Zelle (22) umfasst, die während des Zeitraums derselben Umgebung ausgesetzt ist.

14. Verfahren (100) nach einem der Ansprüche 12 bis 13, wobei das Überprüfen (180), ob der mindestens eine erkannte Fehler mit der Umgebung zusammenhängt, einen Vergleich, für einen bestimmten Zeitraum, von während des Zeitraums durchgeführten und gespeicherten Umgebungsmessungen mit einem vorbestimmten Schwellenwert umfasst.

15. Verfahren (100) nach einem der Ansprüche 1 bis 14, das einen Schritt (190) aufweist, der anhand des digitalen Passes der Zelle (21) bestimmt, ob die Zelle (21) für ein zweites Leben wiederverwendet werden kann oder nicht.

16. Vorrichtung (10) zum Erzeugen eines "digitalen Passes" einer Zelle (21) einer Lithium-Ionen-Batterie (22), wobei der digitale Pass die Form einer Computerdatei (14) annimmt, die eine Reihe von Inzidenzwerten aufweist, die für einen Verlauf von Gesundheitszuständen der Zelle (21) während eines ersten Lebens der Zelle (21) repräsentativ sind, wobei die Vorrichtung (10) aufweist:
- einen Speicher (11), der zum Speichern der Computerdatei (14) ausgelegt ist,
- ein Batteriemanagementsystem (13), das so ausgebildet ist, dass es Strommessungen an der Zelle (21) während einer CV-Phase eines CC-CV-Ladezyklus der Zelle (21) liefert,
- eine Recheneinheit (12), die mit dem Speicher (11) und dem Batteriemanagementsystem (13) verbunden ist, wobei die Recheneinheit (12) so ausgebildet ist, dass sie das Verfahren (100) nach einem der Ansprüche 1 bis 15 durchführt.

## Claims

1. A method (100) for generating a "digital passport" of a cell (21) of a Lithium-Ion battery (20), said digital passport being in the form of a computer file (14) including a set of incidence values representative of a history of states-of-health of the cell (21) over a first service life of the cell (21), the method including, for each "constant-voltage" phase, or CV phase (32), a set of "constant current - constant voltage" charging cycles, or CC-CV charging cycles, of the cell (21) over its first service life:
- collecting (110) a plurality of current measurements performed at the level of the cell (21) during the considered CV phase, said plurality of measurements forming a "floating current" signal,
- deriving (120) the floating current signal to obtain a floating current derivative signal,
- decomposing into empirical modes (130) the floating current derivative signal in order to obtain therefrom a representation in the form of a sum of a residual signal and of one or more intrinsic component(s),
- determining (150) an incidence value representative of a state-of-health of the cell (21), for the considered CV phase, based on the intrinsic components thus obtained,
- memorizing (160) in a computer file (14) the determined incidence value associated with a piece of information on the occurrence time point of the considered CV phase.

2. The method (100) according to claim 1, wherein the determination (150) of the incidence value, for the considered CV phase, comprises:
- calculating (151) an energy for each intrinsic component,
- calculating (152) a total intrinsic energy equal to a sum of the energies of the intrinsic components,
- determining (153) the incidence value, for the considered CV phase, according to the total intrinsic energy thus calculated.

3. The method (100) according to any one of claims 1 to 2, wherein the determination (150) of the incidence value, for the considered CV phase, comprises:
- calculating (156) a spectral density for each intrinsic component,
- calculating (157) a total intrinsic spectral density equal to a sum of the spectral densities of the different intrinsic components,
- determining (159) the incidence value, for the considered CV phase, according to the total intrinsic spectral density thus calculated.

4. The method (100) according to claim 3, wherein the total intrinsic spectral density is normalized with respect to a maximum value of the total intrinsic spectral density.

5. The method (100) according to any one of claims 3 to 4, wherein, for each intrinsic component, the spectral density of the intrinsic component is calculated based on a Hilbert transform of the intrinsic component.

6. The method (100) according to any one of claims 1 to 5, further including, for each CV phase, estimating (140) a statistical reliability of the CV phase, according to the intrinsic components of the floating current derivative signal, and filtering the CV phase if the latter is found to be unreliable.

7. The method (100) according to claim 6, wherein the statistical reliability of the CV phase is estimated according to an entropy calculated for a sum of the intrinsic components of the floating current derivative signal.

8. The method (100) according to claim 6, in combination with claim 2, wherein the statistical reliability of the CV phase is estimated by comparing the total intrinsic energy with a predetermined energy threshold, or with the total intrinsic energies calculated for all or part of the previous CV phases.

9. The method (100) according to any one of claims 1 to 8, including a step of detecting (170) at least one failure of the cell (21) over its first service life based on the incidence values memorized in the computer file (14) forming the digital passport of the cell (21).

10. The method (100) according to claim 9, wherein the detection (170) of said at least one failure includes comparing the incidence value with a predetermined incidence threshold, for one or more consecutive CV phase(s).

11. The method (100) according to any one of claims 9 to 10, wherein the detection (170) of said at least one failure includes comparing a distance between the incidence value and an average incidence value with a predetermined distance threshold, for one or more consecutive CV phase(s).

12. The method (100) according to any one of claims 9 to 11, wherein, when at least one failure is detected, the method further includes verifying (180) whether said at least one detected failure is related to the environment in which the cell has evolved.

13. The method (100) according to claim 12, wherein the verification (180) of whether said at least one detected failure is related to the environment comprises comparing, for a given period, incidence values memorized for said cell (21) during said period with incidence values determined for at least one other cell (22) subjected to the same environment during said period.

14. The method (100) according to any one of claims 12 to 13, wherein the verification (180) of whether said at least one detected failure is related to the environment comprises comparing, for a given period, environment measurements performed and memorized during said period with a predetermined threshold.

15. The method (100) according to any one of claims 1 to 14, including a step of determining (190), based on the digital passport of the cell (21), whether the cell (21) could or could not be reused for a second service life.

16. A device (10) for generating a "digital passport" of a cell (21) of a Lithium-Ion battery (22), said digital passport being in the form of a computer file (14) including a set of incidence values representative of a history of states-of-health of the cell (21) over a first service life of the cell (21), said device (10) including:
- a memory (11) adapted to memorize the computer file (14),
- a battery management system (13) configured to supply current measurements performed at the level of the cell (21) during a CV phase of a CC-CV charging cycle of the cell (21),
- a computing unit (12) connected to the memory (11) and to the battery management system (13), said computing unit (12) being configured to implement the method (100) according to any one of claims 1 to 15.
